Europäisches Patentamt

European Patent Office

Office européen des brevets

(11) Veröffentlichungsnummer: **0 384 928 B1**

## EUROPÄISCHE PATENTSCHRIFT

(45) Veröffentlichungstag der Patentschrift: **23.06.93**

(51) Int. Cl.⁵: **G01R 33/035**

(21) Anmeldenummer: **89103585.9**

(22) Anmeldetag: **01.03.89**

(54) Schaltungsanordnung für ein Gradiometer mit supraleitendem Ouanteninterferometer (SOUID) zur Messung biomagnetischer Felder geringer Intensität.

(43) Veröffentlichungstag der Anmeldung:
**05.09.90 Patentblatt 90/36**

(45) Bekanntmachung des Hinweises auf die
Patenterteilung:
**23.06.93 Patentblatt 93/25**

(84) Benannte Vertragsstaaten:
**DE IT NL**

(56) Entgegenhaltungen:
**GB-A- 2 115 552**

**INSTRUMENTS & EXPERIMENTAL TECHNI-
OUES, Band 30, Nr. 3, Teil 2, Seiten 673-677,
Plenum Publishing Corp., New York, US; V.M.
DROBIN et al.: "Recording unit of squid-
based magnetometer"**

(73) Patentinhaber: **SIEMENS AKTIENGESELL-
SCHAFT
Wittelsbacherplatz 2
W-8000 München 2(DE)**

(72) Erfinder: **Röhrlein, Gerhard, Dr. Ing. Dipl.-Ing.
Klingenweg 9
W-8521 Hessdorf(DE)**

**Beschreibung**

Die Erfindung betrifft eine Schaltungsanordnung nach dem Oberbegriff des Patentanspruchs 1.

Meßanordnungen dieser Art zur Messung biomagnetischer Felder in der Größenordnung von 0,1 pT bis etwa 50 pT, die ein- oder insbesondere auch mehrkanalig ausgeführt sein können, sind beispielsweise aus der DE-OS 32 47 543 bekannt. Solche Meßanordnungen bestehen üblicherweise aus einem Gradiometer erster oder höherer Ordnung und einem mit diesem elektrisch zusammenwirkenden SQUID in einer Schaltungsanordnung, wie sie beispielsweise in "Biomagnetism: 'An Interdisciplinary Approach', Series A: Life Sciences", Vol.66, Plenum Press, New York, 1983, Kap. 4.5: Erne', S.N.: "The SQUID in the "Flux-Locked-Loop", pp. 81-83, schematisch beschrieben ist. Eine Schaltungsanordnung dieser Art in Analogtechnik hat vor allem den Nachteil, daß bei der Messung kleiner magnetischer Gleichfelder insbesondere durch den driftenden Gleichspannungs-Offset des Endverstärkers Ungenauigkeiten auftreten.

Um diese Ungenauigkeiten zu vermeiden, ist bereits versucht worden, mittels einer aufwendigen analogen Schaltungstechnik die durch den driftenden Gleichspannungs-Offset vor allem der Verstärker verursachten Fehler zu kompensieren. Eine solche Anordnung ist beispielsweise in "Biomagnetism: 'An Interdisciplinary Approach', Series A: Life Sciences", Vol. 66, Plenum Press, New York, 1983, Kap. 9.4: Cohen, D.: "Steady fields of the heart", pp. 265-274, beschrieben.

Der Erfindung liegt die Aufgabe zugrunde, eine weniger aufwendige Schaltungsanordnung anzugeben, bei der der vorgenannte Offset-Fehler nicht auftritt.

Diese Aufgabe wird durch die im Patentanspruch 1 beschriebene Erfindung gelöst. Dadurch ist erreicht, daß der dominierende Offset-Fehler, der von dem außerhalb der Regelschleife angeordneten Endverstärker ausgeht, eliminiert ist. Die Offset-Drift des innerhalb der Regelschleife noch verbliebenen Verstärkers wird durch den Rückkopplungs-Regelkreis soweit reduziert, daß er sich innerhalb der Meßtoleranz bewegt. In "Cryogenetics", Vol. 26, No. 11, 1986 'Digital feedback loops for dc SQUIDs', pp. 623-627, ist bereits eine teilweise digital aufgebaute Regelschleife dieser Art beschrieben, bei der jedoch das digitale Signal wieder in ein analoges Signal umgewandelt wird, welches dann als Rückkopplungssignal und als Meßsignal dient. Damit ist aber keine entscheidende Verbesserung im Sinne der Erfindung zu erzielen, weil sich der Endverstärker außerhalb des Digitalkreises befindet.

Anhand von Ausführungsbeispielen wird die erfindungsgemäße Schaltungsanordnung im folgenden näher erläutert. Darin zeigen:

Fig. 1 eine Schaltungsanordnung mit Analog-Digital-Wandlung des Meßsignals bei freier Abtastfrequenz der Analog-Digital-Wandler und

Fig. 2 eine Variante der Schaltungsanordnung nach Fig. 1 mit modulationsfrequenzsynchroner Abtastfrequenz des Analog-Digital-Wandlers.

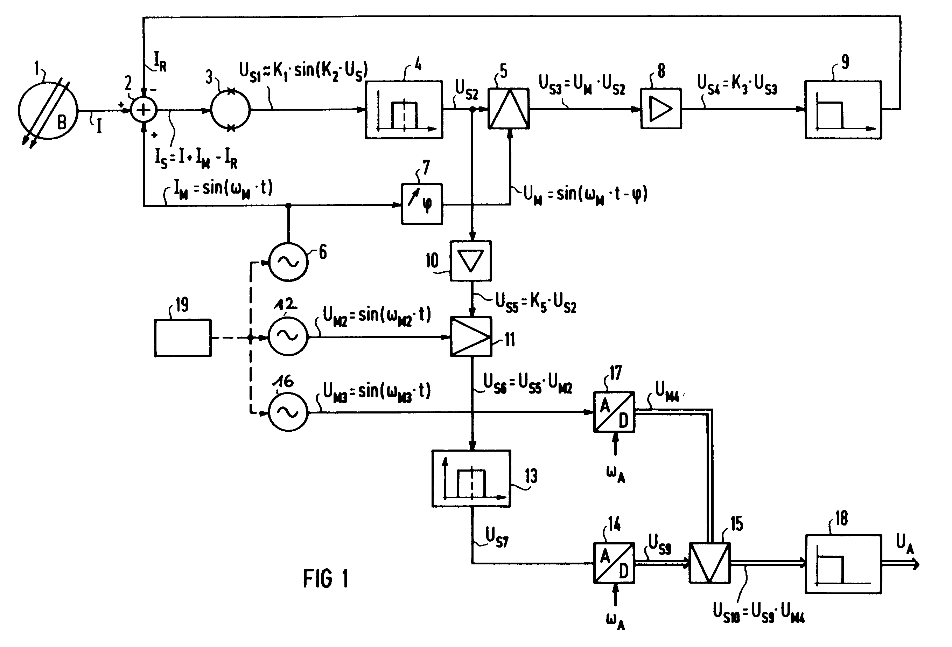

Bei der in Fig. 1 dargestellten Schaltungsanordnung durchdringt das zu messende Magnetfeld B die Aufnahmespule 1 des Gradiometers, die einen entsprechenden Strom I erzeugt, der einem Einkopplungsglied 2 zugeführt ist. In diesem Einkopplungsglied werden dem Strom I der Aufnahmespule ein Rückkopplungsstrom $I_R$ subtraktiv und ein Modulationsstrom $I_M$ additiv zugemischt. Dadurch entsteht am Ausgang des Einkopplungsgliedes 2 ein resultierender Summenstrom $I_S = I + I_M - I_R$. Dieser Summenstrom $I_S$ wird einem SQUID 3 zugeführt, der auch als Strom-Spannungs-Wandler wirkt und an dessen Ausgang eine Wechselspannung $U_{S1} \approx K_1 \cdot \sin(K_2 \cdot U_S)$ entsteht. Diese Wechselspannung gelangt an ein Bandpaßfilter 4, welches aus dem Frequenzgemisch ein Frequenzband mit den Eckwerten $\omega_1$ und $\omega_2$ ausfiltert. Die am Ausgang dieses Bandpaßfilters anstehende modulierte Wechselspannung $U_{S2}$ wird einer Demodulatorstufe 5 zugeführt. Zur Demodulation der Spannung $U_{S2}$ liegt an der Demodulatorstufe 5 die von der Phasenstufe 7 um 90° phasengedrehte, vom Modulationsspannungsgenerator 6 erzeugte Modulationsspannung $U_M = \sin(\omega_M \cdot t - \phi)$ an. Die am Ausgang der Demodulatorstufe 5 auftretende demodulierte Spannung $U_{S3} = U_M \cdot U_{S2}$ wird einem Verstärker 8 zugeführt. Dessen Ausgangsspannung $U_{S4} = K_3 \cdot U_{S3}$ gelangt an den integrierenden Tiefpaß 9, dessen Ausgangsstrom $I_R$ dem Entkopplungsglied 2 als Rückkopplungsstrom zugeleitet ist. Die am Ausgang des Bandpaßfilters 4 auftretende Spannung $U_{S2}$ wird gleichzeitig einem Verstärker 10 zugeführt und gelangt als verstärkte Spannung $U_{S5} = K_5 \cdot U_{S2}$ an eine Demodulatorstufe 11 und wird mit Hilfe einer von einem Modulationsspannungsgenerator 12 erzeugten Modulationsspannung $U_{M2} = \sin(\omega_{M2} \cdot t)$ in eine Zwischenfrequenzspannung $U_{S6} = U_{S5} \cdot U_{M2}$ umgesetzt und einem Bandpaßfilter 13 zugeführt. An dessen Ausgang entsteht die Spannung $U_{S7}$ mit dem Frequenzband

$$(\omega_{M3} - \tfrac{\omega B}{2}) \text{ bis } (\omega_{M3} + \tfrac{\omega B}{2})$$

die an einen Analog-Digital-Wandler 14 gelangt, der diese mit der Frequenz $\omega_A$ digitalisiert und in eine Digitalspannung $U_{S9}$ umwandelt. Diese gelangt an einen Digital-Demodulator 15. Die Demodulation erfolgt mit Hilfe einer ebenfalls digitalisierten Spannungsgröße $U_{M4}$, die durch Digitalisierung der von einem Modulationsspannungsgenerator 16 erzeugten Analog-Wechselspannung $U_{M3}$ = sin ($\omega_{M3}$ . t) mit der Abtastfrequenz $\omega_A$ im Digital-Demodulator 17 gewonnen wird. An Ausgang des Digital-Demodulators 15 entsteht die digitalisierte Wechselspannung $U_{S10}$ = $U_{S9}$ . $U_{M4}$. Diese wird einem digitalen Tiefpaßfilter 18 zugeführt, an dessen Ausgang die digitale Meßspannung $U_A$ entsteht, die ein Maß für das von der Aufnahmespule 1 gemessene Magnetfeld ist.

Die Modulationsspannungsgeneratoren 6, 12 und 16 sind von einer clock 19 synchronisiert. Zwischen den Frequenzen der von den Modulationsspannungsgeneratoren 6, 12 und 16 erzeugten Wechselspannungen und den Eckfrequenzen der Bandpaßfilterstufen bestehen folgende Zusammenhänge:

$$\omega_M > \omega_B; \omega_B = \omega_2 - \omega_1; \omega_{M3} = \omega_M - \omega_{M2}; \quad \frac{\omega_B}{2} < \omega_{M3} < \omega_{M2} < \omega_M \quad \text{und}$$

$$\omega_A \geq 2 \cdot (\omega_{M3} + \frac{\omega_B}{2}).$$

Dabei sind $\omega_M$ die Frequenz der vom Modulationsspannungsgenerator 6 erzeugten Wechselspannung $U_M$ bzw. des Wechselstroms $I_M$; $\frac{\omega_B}{2}$ die Eckfrequenz des integrierenden Tiefpaßfilters 9 sowie des digitalen Tiefpaßfilters 18; $\omega_{M2}$ die Frequenz der vom Modulationsspannungsgenerator 12 erzeugten Spannung $U_{M2}$ und $\omega_{M3}$ die Frequenz der vom Modulationsspannungsgenerator 16 erzeugten Wechselspannung $U_{M3}$ und $\omega_A$ die Abtastfrequenz der Analog-Digital-Wandler 14, 17.

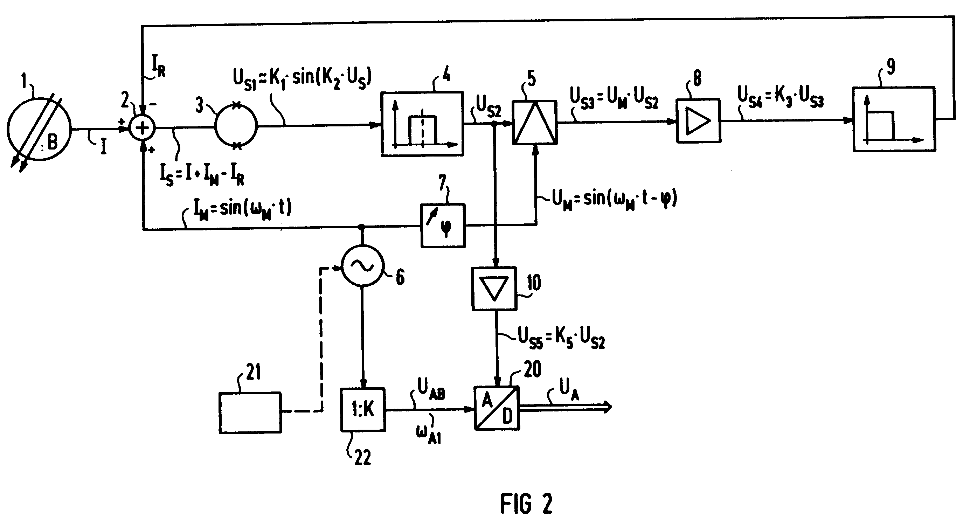

In Fig. 2 ist eine gegenüber derjenigen nach Fig. 1 abgewandelte Schaltungsanordnung dargestellt. Darin haben die mit dem Bezugszeichen 1-10 bezeichneten Schaltungsmittel die gleiche Funktion wie die entsprechenden Schaltungsmittel bei der Anordnung nach Fig. 1. In Abweichung der Schaltungsanordnung nach Fig. 1 wird jedoch die Ausgangsspannung des Verstärkers 10 $U_{S5}$ = $K_5$ . $U_{S2}$ unmittelbar einem demodulierenden Analog-Digital-Wandler 20 zugeführt. Dieser erhält seine Abtastfrequenz $\omega_{A1}$ aus der Wechselspannung des Modulationsspannungsgenerators 6, der von einer clock 21 synchronisiert ist. Die vom Modulationsspannungsgenerator 6 erzeugte Modulationsspannung $U_M$ = sin ($\omega_M$ • t) wird einem Frequenzteiler 22 zugeführt, der die Frequenz $\omega_M$ durch den Faktor K teilt und die entsprechende Ausgangsspannung $U_{AB}$ als Abtastsignal dem demodulierenden Analog-Digital-Wandler 20 zuführt. Dieser bildet daraus die digitialisierte Meßspannung $U_A$. Dabei ergeben sich zwischen den Frequenzen der vom Modulationsspannungsgenerator 6 erzeugten Wechselspannung und den Eckfrequenzen der Filter $S_9$ folgende Zusammenhänge:

$$\omega_B = \omega_2 - \omega_1; \omega_M = K \cdot \omega_{A1} \text{ und } \omega_{A1} > \omega_B.$$

Dabei ist $\frac{\omega_B}{2}$ die Eckfrequenz der Filterstufe 9; $\omega_1$ und $\omega_2$ sind die Eckwerte des Bandpaßfilters 4 und $\omega_{A1}$ ist die Abtastfrequenz des demodulierenden Analog-Digital-Wandlers 20.

Die Schaltungsanordnung nach Fig. 2 hat gegenüber dergenigen nach Fig. 1 den Vorteil, daß kein digitales Tiefpaßfilter erforderlich ist, weil keine unerwünschten Spektralanteile bei der Analog-/Digital-Wandlung entstehen. Voraussetzung für das Funktionieren dieser Schaltung ist jedoch, daß das Modulationssignal $U_M$ mit der Modulationsfrequenz $\omega_M$ und das Abtastsignal $U_{AB}$ mit der Abtastfrequenz $\omega_{A1}$ phasenstarr gekoppelt sind.

**Patentansprüche**

1. Schaltungsanordnung für ein Gradiometer mit einem supraleitenden Quanteninterferometer (3) zur Messung biomagnetischer Felder geringer Intensität, bei der der von einer Gradiometerspule (1) des Gradiometers erzeugte, von der Intensität des gemessenen Magnetfeldes abhängige Pickup-Strom (I) einem Einkopplungsglied (2) zugeführt wird, welches dem Pickup-Strom (I) einen von einem Modulationsspannungsgenerator (6) erzeugten Modulationsstrom ($I_M$) additiv und einen Rückkopplungsstrom ($I_R$) subtraktiv zumischt und den resultierenden Strom ($I_S$) dem Quanteninterferometer (3) als Eingangsgröße zuführt, welches eine mit dem resultierenden Strom ($I_S$) modulierte Ausgangsgröße als modulierte Spannung ($U_{S1}$) über ein Bandpaßfilter (4) einem Demodulator (5) zuleitet, der die modulierte Ausgangsspannung ($U_{S2}$) des Bandpaßfilters (4) mit der um 90° phasenverschobenen Modulationsspannung ($U_M$) multipliziert und die dadurch entstandene demodulierte Spannung ($U_{S3}$) über einen Verstärker (8) einem integrierenden Tiefpaßfilter (9) zuführt, dessen Ausgangssignal als Rückkopp-

EP 0 384 928 B1

lungsstrom ($I_R$) in das Einkopplungsglied (2) eingespeist wird, **dadurch gekennzeichnet,** daß die modulierte Ausgangsspannung ($U_{S2}$) des Bandpaßfilters (4) außerdem zur Digitalisierung und Quantisierung einem A/D-Wandler (14; 20) zugeführt ist, dessen demoduliertes Ausgangssignal ($U_{S10}$) tiefpaßgefiltert als Meßsignal ($U_A$) dient.

**2.** Anordnung nach Anspruch 1, **dadurch gekennzeichnet,** daß die modulierte Ausgangsspannung ($U_{S2}$) des Bandpaßfilters (4) über einen Verstärker (10) einer Demodulatorstufe (11) zugeleitet ist, die aus der Ausgangsspannung ($U_{S5}$) des Verstärkers (10) und einer von einem mit dem Modulationsspannungsgenerator (6) synchron arbeitenden zweiten Modulations-Spannungsgenerator (12) erzeugten zweiten Modulationsspannung ($U_{M2}$) eine analoge Zwischenfrequenzspannung ($U_{S6}$) bildet, die über ein Bandpaßfilter (13) einem A/D-Wandler (14) als Eingangsspannung zugeführt ist, dessen Ausgangsspannung ($U_{S9}$) an einen Digital-Demodulator (15) gelangt, der diese Spannung mit einer digitalisierten, von einem synchron zu dem Modulationsspannungsgenerator (6) arbeitenden dritten Modulationsspannungsgenerator (16) erzeugten dritten Modulationsspannung ($U_{M3}$) digital demoduliert und diese demodulierte Spannung ($U_{S10}$) einem digitalen Tiefpaßfilter (18) zuführt, dessen Ausgangssignal ($U_A$) als Meßsignal dient.

**3.** Anordnung nach Anspruch 1, **dadurch gekennzeichnet,** daß die modulierte Ausgangsspannung ($U_{S2}$) des Bandpaßfilters (4) über einen Verstärker (10) einem A/D-Wandler (20) zugeführt ist, der als digitaler Demodulator arbeitet und dem eine phasenstarr mit der vom Modulationsspannungsgenerator (6) erzeugten Modulationsspannung ($U_M$) gekoppelte Abtastspannung ($U_{AB}$) zugeführt ist, deren Frequenz $\omega_{A1}$ ein ganzzahliger Teiler der Modulationsspannungsfrequenz $\omega_M$ ist, und dessen digitalisierte Ausgangsspannung ($U_A$) als Meßsignal dient.

**Claims**

**1.** Circuit arrangement for a gradiometer having a superconducting quantum interferometer (3) for measuring low-intensity biomagnetic fields, in which arrangement the pick-up current (I) generated by a gradiometer coil (1) of the gradiometer and dependent upon the intensity of the magnetic field measured is fed to a coupling element (2) which additively mixes the pick-up current (I) with a modulation current ($I_M$) generated by a modulation voltage generator (6) and subtractively mixes the pick-up current (I) with a feedback current ($I_R$) and feeds the resulting current ($I_S$) as an input variable to the quantum interferometer (3), which supplies an output variable modulated with the resulting current ($I_S$) to a demodulator (5) as a modulated voltage ($U_{S1}$) by way of a bandpass filter (4), with the demodulator (5) multiplying the modulated output voltage ($U_{S2}$) of the bandpass filter (4) by the modulation voltage ($U_M$), which is phase-shifted by 90°, and feeding the resulting demodulated voltage ($U_{S3}$) by way of an amplifier (8) to an integrating low-pass filter (9), the output signal of which is supplied to the coupling element (2) as the feedback current ($I_R$),
characterised in that the modulated output voltage ($U_{S2}$) of the bandpass filter (4) is further fed to an analog-to-digital converter (14; 20) for digitization and quantization, the demodulated output signal ($U_{S10}$) of this analog-to-digital converter serving as a measuring signal ($U_A$) after passing through a low-pass filter.

**2.** Arrangement according to claim 1,
characterised in that the modulated output voltage ($U_{S2}$) of the bandpass filter (4) is supplied by way of an amplifier (10) to a demodulator stage (11) which forms, from the output voltage ($U_{S5}$) of the amplifier (10) and a second modulation voltage ($U_{M2}$) generated by a second modulation voltage generator (12) operating synchronously with the modulation voltage generator (6), an analog intermediate frequency voltage ($U_{S6}$) which is fed by way of a bandpass filter (13) to an analog-to-digital converter (14) as the input voltage, the output voltage ($U_{S9}$) of the analog-to-digital converter (14) arriving at a digital demodulator (15) which digitally demodulates this voltage with a digitized third modulation voltage ($U_{M3}$) generated by a third modulation voltage generator (16) operating synchronously with the modulation voltage generator (6) and feeds this demodulated voltage ($U_{S10}$) to a digital low-pass filter (18), the output signal ($U_A$) of which serves as a measuring signal.

**3.** Arrangement according to claim 1,
characterised in that the modulated output voltage ($U_{S2}$) of the bandpass filter (4) is fed by way of an amplifier (10) to an analog-to-digital converter (20) which operates as a digital demodulator and to

4

which there is fed a sampling voltage ($U_{AB}$) coupled in a phase-locked manner with the modulation voltage ($U_M$) generated by the modulation voltage generator (6), with the frequency $\omega_{A1}$ of the sampling voltage ($U_{AB}$) being a whole divisor of the modulation voltage frequency $\omega_M$, and the digitized output voltage ($U_A$) of the analog-to-digital converter (20) serving as a measuring signal.

**Revendications**

1. Circuit pour un gradiomètre qui comprend un interféromètre quantique supraconducteur (3) pour une mesure de champs biomagnétiques de faible intensité, dans lequel le courant récupéré (I) créé par une inductance de gradiométrie (1) du gradiomètre et dépendant de l'intensité du champ magnétique mesuré, et envoyé à un élément de couplage (2), qui mélange au courant récupéré (I), de manière additive un courant modulateur créé par un générateur de tension de modulation (6), et de manière soustractive un courant de réinjection (IR) et qui envoie le courant résultant ($I_S$), sous forme d'une grandeur d'entrée, à l'interféromètre quantique (3), qui conduit, par l'intermédiaire d'un filtre passe-bande (4), une grandeur de sortie modulée comprenant le courant résultant ($I_S$) sous la forme d'une tension modulée ($U_{S1}$), à un démodulateur (5), qui multiplie la tension de sortie modulée ($U_{S2}$) du filtre passe-bande (4) par une tension de modulation ($U_M$) qui est en quadrature de phase, et dont la tension modulée ($U_{S3}$) extraite alimente, par l'intermédiaire d'un amplificateur (8), un filtre passe-bas dont le signal de sortie est réinjecté comme courant de réinjection ($I_R$) à l'élément de couplage (2), caractérisé en ce que la tension de sortie modulée ($U_{S2}$) du filtre passe-bande (4) est envoyée, pour une numérisation et une quantification, à un transducteur A-D (14; 20) dont le signal de sortie démodulé ($U_{S10}$), filtré par un filtre passe-bas, sert de signal de mesure ($U_A$).

2. Dispositif selon la revendication 1, caractérisé en ce que la tension de sortie modulée ($U_{S2}$) du filtre passe-bande (4) est conduite par l'intermédiaire d'un amplificateur (10) à un démodulateur (11), qui, de la tension de sortie ($U_{S5}$) de l'amplificateur (10) et d'une deuxième tension de modulation ($U_{M2}$) créé par un deuxième générateur de tension de modulation (12) travaillant de manière synchrone avec le générateur de tension de modulaiton (6), forme une tension de fréquence intermédiaire analogique ($U_{S6}$), qui est envoyée, par l'intermédiaire d'un filtre passe-bande (13), comme tension d'entrée à un transducteur A-D, dont la tension de sortie ($U_{S9}$) parvient à un démodulateur numérique (15) qui démodule numériquement cette tension avec une troisième tension de modulation ($U_{M3}$) créée par un troisième générateur de tension de modulation (16) travaillant de manière synchrone avec le générateur de tension de modulation (6) et cette tension démodulée ($U_{S10}$) est envoyée à un filtre passe-bas numérique (18) dont le signal de sortie ($U_A$) sert de signal de mesure.

3. Dispositif selon la revendication 1, caractérisé en ce que le signal de sortie modulé ($U_{S2}$) du filtre passe-bande (4) est envoyé par l'intermédiaire d'un amplificateur (10) à un transducteur A-D (20) qui travaille comme démodulateur numérique et auquel est envoyée une tension de balayage ($U_{AB}$) à phase fixe couplée avec la tension de modulation ($U_M$) créée par le générateur de tension de modulation (6), dont la fréquence $\omega_{A1}$ est une partie entière de la fréquence de tension de modulation $\omega_M$, et dont la tension de sortie numérique ($U_A$) sert de signal de mesure.

EP 0 384 928 B1

$I_R$

$U_{S1} \approx K_1 \cdot \sin(K_2 \cdot U_S)$

$U_{S2}$

$U_{S3} = U_M \cdot U_{S2}$

$U_{S4} = K_3 \cdot U_{S3}$

$I$

$I_S = I + I_M - I_R$

$I_M = \sin(\omega_M \cdot t)$

$\varphi$

$U_M = \sin(\omega_M \cdot t - \varphi)$

$U_{S5} = K_5 \cdot U_{S2}$

$U_{M2} = \sin(\omega_{M2} \cdot t)$

$U_{S6} = U_{S5} \cdot U_{M2}$

$U_{M4}$

$U_{M3} = \sin(\omega_{M3} \cdot t)$

$\omega_A$

$U_{S7}$

$U_{S9}$

$U_A$

$\omega_A$

$U_{S10} = U_{S9} \cdot U_{M4}$

FIG 1

FIG 2

$U_{S1} \approx K_1 \cdot \sin(K_2 \cdot U_S)$

$I_S = I + I_M - I_R$

$I_M = \sin(\omega_M \cdot t)$

$U_{S3} = U_M \cdot U_{S2}$

$U_{S4} = K_3 \cdot U_{S3}$

$U_M = \sin(\omega_M \cdot t - \varphi)$

$U_{S5} = K_5 \cdot U_{S2}$

$U_{AB}$

$\omega_{A1}$

$U_A$

EP 0 384 928 B1